# EUROPEAN PATENT APPLICATION

(11) **EP 4 517 497 A1**
(43) Date of publication of application: **05.03.2025**
(21) Application number: 24194700.1
(22) Date of filing: 15.08.2024
(51) Int. Cl.: G06F 3/041, G06F 3/044

(54) **TOUCH DISPLAY DEVICE**

(30) Priority: 31.08.2023 KR 20230115323
(71) Applicant: LG Display Co., Ltd., Seoul 07336 (KR)
(72) Inventor: KIM, SungChul, Gyeonggi-do 10845 (KR); KIM, JuHan, Gyeonggi-do 10845 (KR); KIM, Jinseong, Gyeonggi-do 10845 (KR); LEE, Haewon, Gyeonggi-do 10845 (KR)
(74) Representative: Bryn-Jacobsen, Caelia

(57) **Abstract**

A touch display device comprises: a display panel including a substrate having a first area in a center of the substrate and a second area that surrounds the first area, a plurality of first pixels in the first area of the substrate, and a plurality of second pixels in the second area of the substrate; and a touch sensor on the display panel, the touch sensor configured to sense touch and includes a plurality of first sensing electrodes in the first area and a plurality of second sensing electrodes in the second area. The plurality of first pixels and the plurality of second pixels have different densities, and the plurality of first sensing electrodes and the plurality of second sensing electrodes have different densities.

## Description

### CROSS-REFERENCE TO RELATED APPLICATION

This application claims the priority of Republic of Korea Patent Application No. 10-2023-0115323 filed on August 31, 2023.

### BACKGROUND

### Field

The present disclosure relates to a touch display device.

### Description of the Related Art

As it enters an information era, a display field which visually expresses electrical information signals has been rapidly developed, and in response to this, various display devices having excellent performances such as thin-thickness, light weight, and low power consumption have been developed. Examples of such a display device may include a liquid crystal display (LCD) device, an organic light emitting display (OLED) device, and the like.

An applicable range is diversified to personal digital assistants as well as monitors of computers and televisions and a display device with a large display area and a reduced volume and weight is being studied.

Further, the display device may include a display panel which displays images and a touch panel which is disposed on the display panel to receive a touch input and the touch panel may include a plurality of sensing electrodes. The display device (or an input sensing device) may find a touched point by sensing a change in the capacitance formed in the plurality of sensing electrodes.

### SUMMARY

An object to be achieved by the present disclosure is to provide a touch display device including a flexible outer peripheral area.

Another object to be achieved by the present disclosure is to provide a touch display device which utilizes a connection line disposed in an outer peripheral area as a part of a touch electrode.

Objects of the present disclosure are not limited to the above-mentioned objects, and other objects, which are not mentioned above, can be clearly understood by those skilled in the art from the following descriptions.

In one example, a touch display device comprises: a display panel including a substrate having a first area in a center of the substrate and a second area that surrounds the first area, a plurality of first pixels in the first area of the substrate, and a plurality of second pixels in the second area of the substrate; and a touch sensor on the display panel, the touch sensor configured to sense touch and includes a plurality of first sensing electrodes in the first area and a plurality of second sensing electrodes in the second area, wherein a density of the plurality of first pixels in the first area is different from a density of the plurality of second pixels in the second area, and a density of the plurality of first sensing electrodes in the first area is different from a density of the plurality of second sensing electrodes in the second area. In one example, a touch display device comprises: a display panel comprising a first area of the display panel and a second area corresponding to a curved edge of the display panel that surrounds the first area, a plurality of first pixels in the first area of the display panel that are configured to emit light, and a plurality of second pixels in the second area of the display panel that are configured to emit light; and a touch sensor on the display panel, the touch sensor including: a plurality of first sensing electrodes in the first area, the plurality of first sensing electrodes configured to sense touch of the first area; a plurality of second sensing electrodes that are spaced apart from each other in the second area, the plurality of second sensing electrodes configured to sense touch of the second area; and a plurality of connection lines in the second area, at least one connection line from the plurality of connection lines between a pair of second sensing electrodes from the plurality of second sensing electrodes and electrically connecting together the pair of second sensing electrodes
Other detailed matters of the exemplary examples are included in the detailed description and the drawings.

According to the exemplary examples of the present disclosure, in the touch display device, the second pixel disposed in the second area may be disposed with a pixel density lower than the first pixel disposed in the first area. Therefore, in the second area which is an outer peripheral area, the touch display device can be modified so that the second area which is an outer peripheral area may be designed to have a rounded shape.

Further, according to the exemplary examples of the present disclosure, in the case of the touch display device, the image may be displayed not only in the first area which is a center area, but also in the second area which is an outer peripheral area. Therefore, the display surface may be ensured to the maximum and the bezel area may be minimized or reduced.

The effects according to the present disclosure are not limited to the contents exemplified above, and more various effects are included in the present specification.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a plan view schematically illustrating a touch display device according to exemplary examples of the present disclosure;
FIG. 2 is a cross-sectional view schematically illustrating a touch display device according to exemplary examples of the present disclosure;
FIG. 3 is an enlarged view illustrating an example of an FF part of a display panel included in a touch display device of FIG. 1 according to exemplary examples of the present disclosure;
FIG. 4 is an enlarged view illustrating an example of an FF part of a touch sensor included in a touch display device of FIG. 1 according to exemplary examples of the present disclosure;
FIG. 5 is a cross-sectional view illustrating an example taken along the line I-I' illustrated in FIG. 4 according to exemplary examples of the present disclosure;
FIG. 6 is an enlarged view illustrating an example enlarging a part of a second area of a touch display device of FIG. 1 according to exemplary examples of the present disclosure;
FIG. 7 is a cross-sectional view illustrating an example taken along the line II-II' of FIG. 6 according to exemplary examples of the present disclosure; and
FIG. 8 is a cross-sectional view illustrating an example taken along the line III-III' of FIG. 6 according to exemplary examples of the present disclosure.

### DETAILED DESCRIPTION

Advantages and characteristics of the present disclosure and a method of achieving the advantages and characteristics will be clear by referring to exemplary examples described below in detail together with the accompanying drawings. However, the present disclosure is not limited to the exemplary examples disclosed herein but will be implemented in various forms. The exemplary examples are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary examples of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "comprising" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various examples of the present disclosure can be partially or entirely adhered to or combined with each other and can be interlocked and operated in technically various ways, and the examples can be carried out independently of or in association with each other.

Hereinafter, a touch display device according to exemplary examples of the present disclosure will be described in detail with reference to accompanying drawings.

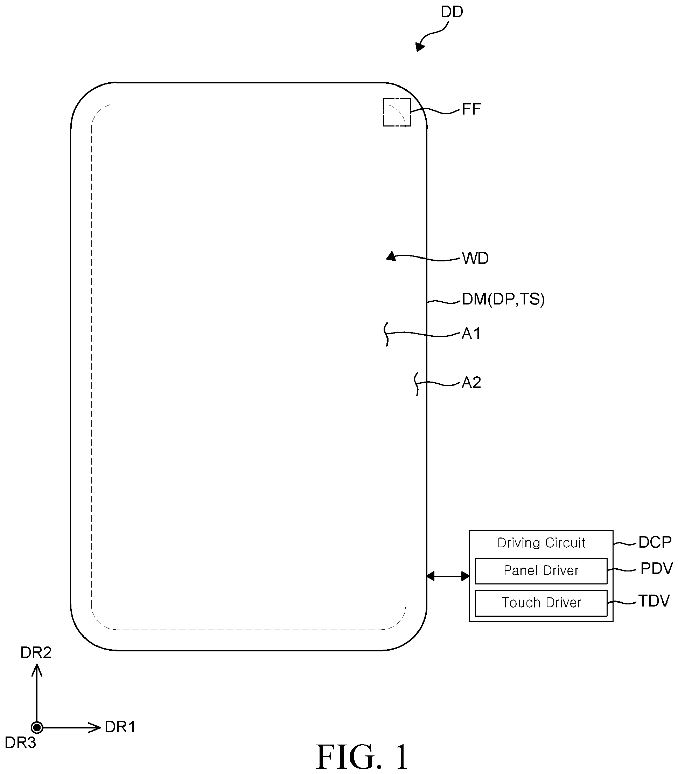

FIG. 1 is a plan view schematically illustrating a touch display device according to exemplary examples of the present disclosure.

In FIG. 1, a display module DM and a driving circuit DCP for driving the display module DM are included in a touch display device DD according to exemplary examples of the present disclosure are illustrated.

Even though in FIG. 1, it is illustrated that the touch display device DD is implemented in the form of a smart phone, it is not limited thereto and the touch display device DD may be implemented as various electronic devices (for example, a smart watch or a tablet, personal computer (PC)).

In the meantime, for the convenience of description, even though in FIG. 1, the display module DM and the driving circuit DCP are separately illustrated, the exemplary example of the present disclosure is not limited thereto. According to the exemplary example, all or a part of the driving circuit DCP may be integrally implemented on the display module DM.

Referring to FIG. 1, the touch display device DD according to the exemplary examples of the present disclosure may include a display module DM including a display panel DP and a touch sensor TS and a driving circuit DCP for driving the display module DM. According to the exemplary example, the touch display device DD may further include a window WD which covers the display module DM.

The touch display device DD may be provided with various shapes. For example, the touch display device DD may be provided as a rectangular planar shape having two pairs of parallel sides, but the exemplary example of the present disclosure is not limited thereto. When the touch display device DD is provided as a rectangular planar shape, any one pair of sides, of two pairs of sides, may be longer than the other pair of sides. In the meantime, for the convenience of description, in FIG. 1, it is illustrated that the touch display device DD has a rectangular shape having one pair of longer sides and one pair of shorter sides, and an extending direction of one pair of longer sides is a second direction DR2 and an extending direction of one pair of shorter sides is a first direction DR1. According to the exemplary example, as illustrated in FIG. 1, the touch display device DD which is provided as a rectangular planar shape may have a rounded corner in which one long side and one short side are in contact with each other. However, this is just illustrative, so that the shape of the touch display device DD is not limited thereto. For example, the touch display device DD may have an angled shape, etc. at the corner in which one long side and one short side intersect.

In the meantime, front surfaces (or top surfaces) and rear surfaces (or bottom surfaces) of components or units of the touch display device DD to be described below may be distinguished by the third direction DR3. However, the first to third directions DR1, DR2, and DR3 illustrated in the specification are just illustrative and the first to third directions DR1, DR2, and DR3 are relative concepts to be converted into other directions. Hereinafter, for the convenience of description, the same reference numerals refer to the first to third directions DR1, DR2, and DR3, respectively.

In the meantime, in the present specification, when it is represented as "overlapping", it means that two components overlap in the thickness direction (that is, the third direction DR3) of the touch display device DD, unless otherwise defined.

The touch display device DD may be a flat display device, a flexible display device, a curved display device, a foldable display device, a bendable display device, or the like. Further, the touch display device DD may be applied to a transparent display device, a head-mounted display device, a wearable display device, or the like.

In one exemplary example, at least a part of the touch display device DD may have flexibility. For example, at least a part of the touch display device DD may have stretchability.

To be more specific, the touch display device DD may include a display surface with a flat center area and a display surface with a rounded outer peripheral area (for example, an edge area). For example, in the touch display device DD, a front surface including a center area and an outer peripheral area (for example, an edge area) which encloses the center area may be set as a display surface.

For example, the touch display device DD may include a first area A1 and a second area A2 excluding the first area A1. For example, the second area A2 may be defined as an area which encloses the first area A1. For example, the first area A1 may correspond to the above-described center area and the second area A2 may correspond to the above-described outer peripheral area (for example, an edge area). In the meantime, the first area A1 may occupy the most area of the display surface.

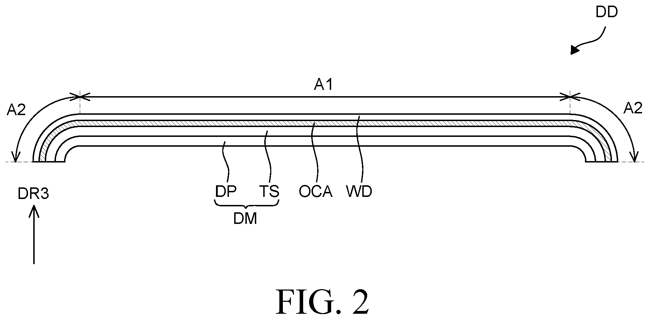

In one exemplary example, the first area A1 is an area corresponding to the center area of the touch display device DD and may have a flat shape and the second area A2 is an area corresponding to the outer peripheral area (edge area) of the touch display device DD and may have a rounded shape. This will be described in more detail with reference to FIGS. 2 to 4.

The touch display device DD may display images through the display surface (for example, the first area A1 and the second area A2). Here, the display surface may be defined as an area in which images are displayed. For example, the touch display device DD may include a display module DM and the display panel DP may include a plurality of pixels (or a plurality of sub pixels) for displaying images.

In one exemplary example, the display surface of the touch display device DD, for example, at least one area of the first area A1 and the second area A2 may be used as an area which recognizes a user's touch input (for example, a sensing area or a touch area). That is, at least a part of the display surface of the touch display device DD may be set as a sensing area. For example, the display module DM included in the touch display device DD may further include a touch sensor TS and the touch sensor TS may include a plurality of sensing electrodes to sense the user's touch input. However, the exemplary example of the present disclosure is not limited thereto. Therefore, according to an exemplary example, the display surface of the touch display device DD, for example, both the first area A1 and the second area A2 may be used as an area which recognizes a user's touch input (for example, a sensing area or a touch area).

The driving circuit DCP may drive the display module DM. For example, the driving circuit DCP may output a data signal corresponding to the image data to the plurality of pixels included in the display panel DP or may receive an electric signal (for example, a sensing signal) received from the plurality of sensing electrodes to output the driving signal to the plurality of sensing electrodes included in the touch sensor TS. The driving circuit DCP may sense the user's touch input using the electric signals.

According to exemplary examples, the driving circuit DCP may include a panel driver PDV and a touch driver TDV (or a sensor driver). For the convenience of description, even though in FIG. 1, it is illustrated that the panel driver PDV and the touch driver TDV are separate configurations, the exemplary example of the present disclosure is not limited thereto. For example, at least a part of the touch driver TDV may be integrated together with the panel driver PDV or may interwork with the panel driver PDV

The panel driver PDV may supply a data signal corresponding to an image data signal to the plurality of pixels while sequentially scanning the plurality of pixels included in the display panel DP. In this case, the display panel DP may display the image corresponding to the image data.

The touch driver TDV may detect a user touch input, etc. based on a sensing signal received from the plurality of sensing electrodes included in the touch sensor TS.

FIG. 2 is a cross-sectional view schematically illustrating a touch display device according to exemplary examples of the present disclosure.

Referring to FIGS. 1 and 2, the touch display device DD may include a display module DM and a window WD.

The display module DM may include a display panel DP and a touch sensor TS.

The touch sensor TS may be directly disposed on the display panel DP or disposed on the display panel DP with a separate layer, such as an adhesive layer or a substrate (or an insulating layer), therebetween.

The display panel DP may display images. The display panel DP may be a display panel which emits light by itself (e.g., self-emissive) such as an organic light emitting display panel (OLED panel). However, the exemplary example of the present disclosure is not limited thereto and for example, as the display panel DP, a non-emitting display panel, such as a liquid crystal display (LCD) panel, an electrophoretic display (EPD) panel, an electro-wetting display (EWD) panel, may be used. In the meantime, when the non-emitting display panel is used as the display panel DP, the touch display device DD may include a backlight unit which supplies light to the display panel DP.

The touch sensor TS is disposed on a surface of the display panel DP on which the image is displayed to receive the user's touch input. The touch sensor TS may recognize a touch event of the touch display device DD through a user's hand or a separate input unit. The touch sensor TS may recognize the touch event in a capacitance manner. For example, the touch sensor TS may sense the touch input in a mutual capacitance manner or a self-capacitance manner.

The window WD for protecting an exposed surface of the display module DM may be provided on the display module DM. The window WD may protect the display module DM from the external impacts and provide an input surface and/or a display surface to the user. The window WD may be coupled to the display module DM using an optically clear adhesive member (OCA).

The window WD may have a multilayered structure selected from a glass substrate, a plastic film, or a plastic substrate. The multilayered structure may be formed using a continuous process or an adhering process using an adhesive layer. All or a part of the window WD has a flexibility.

In the meantime, as described with reference to FIG. 1, in one exemplary example, the first area A1 is an area corresponding to the center area of the touch display device DD and may be a flat shape and the second area A2 is an area corresponding to the outer peripheral area (edge area) of the touch display device DD and may be a rounded shape or curved shape. Thus, the second area A2 is a curved edge of the display panel DP.

For example, as illustrated in FIG. 2, the second area A2 may have a rounded shape which is bent along a strain direction (for example, an arbitrary direction on a plane defined by a first direction DR1 and a second direction DR2).

In one exemplary example, the touch display device DD, for example, a part of the display panel DP corresponding to the second area A2 may be bendable or stretchable. For example, the part of the display panel DP corresponding to the second area A2 may have not only flexibility, but also stretchability. Accordingly, the touch display device DD corresponding to the second area A2 may freely deform the shape so as to be designed to have a rounded shape in the corresponding area.

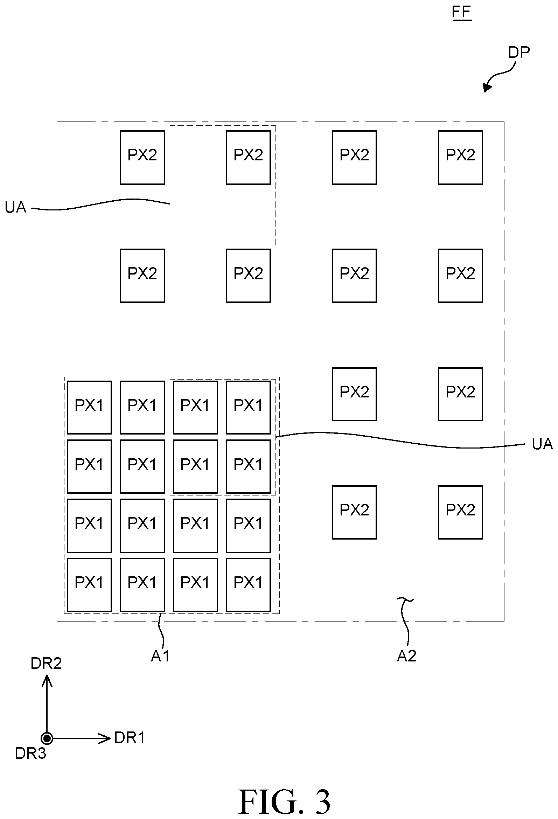

FIG. 3 is an enlarged view illustrating an example of an FF part of a display panel included in a touch display device of FIG. 1 according to one example.

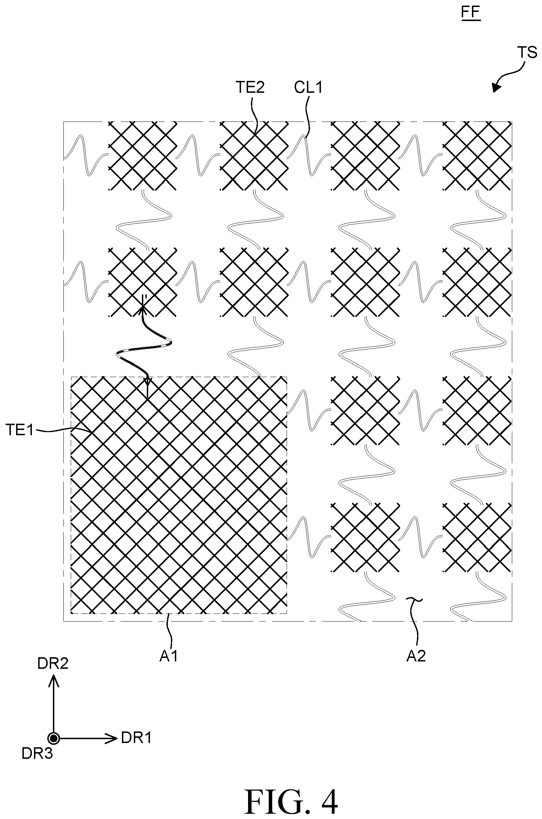

FIG. 4 is an enlarged view illustrating an example of an FF part of a touch sensor included in a touch display device of FIG. 1 according to one example.

In FIG. 3, the placement relationship of the plurality of pixels PX1 and PX2 included in the display panel DP in the first area A1 and the second area A2 is illustrated and in FIG. 4, a placement relationship of the plurality of sensing electrodes TE1 and TE2 included in the touch sensor TS in the first area A1 and the second area A2 is illustrated.

First, referring to FIGS. 1, 2, and 3, the display panel DP may include the first area A1 and the second area A2. Here, as described above, the first area A1 is an area corresponding to the center area of the touch display device DD and may have a flat shape and the second area A2 is an area corresponding to the outer peripheral area (edge area) of the touch display device DD and may have a rounded shape.

The plurality of pixels PX1 and PX2 may be provided on the display panel DP. According to the exemplary examples, each of the plurality of pixels PX1 and PX2 may include at least one light emitting diode. According to the exemplary examples, the light emitting diode may be configured by an inorganic light emitting diode, such as an organic light emitting diode, a micro light emitting diode (LED), a quantum dot light emitting diode. Further, the light emitting diode may be a light emitting diode in which an organic material and an inorganic material are mixed. Moreover, each of the plurality of pixels PX1 and PX2 includes a single light emitting diode or in another exemplary example, each of the plurality of pixels PX1 and PX2 includes a plurality of light emitting diodes. The plurality of light emitting diodes may be connected to each other in series, in parallel, or in serial-parallel. The touch display device DD drives the plurality of pixels PX1 and PX2 so as to correspond to the input image data to display the image on the first area A1 and the second area A2.

In the meantime, each of the plurality of pixels PX1 and PX2 may include at least one sub pixel, among a red sub pixel, a green sub pixel, and a blue sub pixel. According to the exemplary example, at least some of the plurality of pixels PX1 and PX2 may further include a white sub pixel.

In one exemplary example, the display panel DP may have a different pixel density for every area.

For example, the display panel DP may include a plurality of first pixels PX1 disposed on the first area A1 and a plurality of second pixels PX2 disposed on the second area A2. Here, the first pixels PX1 may be disposed on the first area A1 with a first pixel density and the second pixels PX2 may be disposed on the second area A2 with a second pixel density which is less than the first pixel density.

Here, the pixel density may be defined as a total area of a part in which actual pixels are disposed, with respect to the entire area of the corresponding area or defined as a total area of pixels included in a predetermined unit area. Here, the area in which each pixel is disposed may be an area of an emission surface of a light emitting diode included in each pixel. For example, when the pixel includes an organic light emitting diode, an area of the pixel may be an area of an anode electrode exposed between pixel definition films, or an area of an emission layer.

To be more specific, as illustrated in FIG. 3, in the first area A1 and the second area A2, a unit area UA with the same size may be defined.

Here, on the basis of the unit area UA, the first pixels PX1 disposed on the first area A1 may be disposed with a first pixel density which is relatively large. For example, on the first area A1, the first pixels PX1 may be disposed at a high PPI. Therefore, an image with a high resolution may be displayed in the first area A1 which occupies the most area of the display surface and corresponds to the center area.

Here, on the basis of the unit area UA, the second pixel PX2 disposed on the second area A2 may be disposed with a second pixel density which is relatively small compared to the first pixel density. Here, the second pixel density is smaller than the first pixel density and for example, the first pixel density may be four times the second pixel density, but this is just illustrative and the exemplary example of the present disclosure is not limited thereto. For example, on the second area A2, the second pixels PX2 may be disposed at a PPI lower than a PPI of the first pixels PX1 of the first area A1.

Next, further referring to FIG. 4, the touch sensor TS may include the first area A1 and the second area A2. Here, as described above, the first area A1 is an area corresponding to the center area of the touch display device DD and may have a flat shape and the second area A2 is an area corresponding to the outer peripheral area (edge area) of the touch display device DD and may have a rounded shape.

The plurality of sensing electrodes TE1 and TE2 may be provided on the touch sensor TS. The plurality of sensing electrodes TE1 and TE2 may have a mesh pattern or a mesh structure. The mesh pattern may include mesh lines which are metal lines forming at least one mesh hole (or opening). At least one mesh hole (or opening) corresponds to the emission area of the pixel to form a path through which light emitted from the pixel passes. The mesh hole may have a rhombic planar shape by the mesh lines, but is not limited thereto. The plurality of sensing electrodes TE1 and TE2 has a mesh pattern to reduce a parasitic capacitance with the electrodes of the display panel DP. Further, when the plurality of sensing electrodes TE1 and TE2 with a mesh pattern is disposed on the display panel DP, the flexibility of the touch display device DD may be improved.

The plurality of sensing electrodes TE1 and TE2 may include aluminum, copper, chrome, nickel, titanium, or the like. According to the exemplary example, the plurality of sensing electrodes TE1 and TE2 may have a triple-layered structure of titanium/aluminum/titanium. However, the present disclosure is not limited thereto and the plurality of sensing electrodes TE1 and TE2 may be formed with various metals.

The plurality of sensing electrodes TE1 and TE2 are electrically connected to the signal lines connected to the driving circuit DCP (for example, the touch driver TDV) to receive a driving signal from the driving circuit DCP (for example, the touch driver TDV) or output a sensing signal to the driving circuit DCP (for example, the touch driver TDV).

In one exemplary example, the plurality of sensing electrodes TE1 and TE2 included in the touch sensor TS may be disposed with different densities for every area.

For example, the touch sensor TS may include a plurality of first sensing electrodes TE1 disposed on the first area A1 and a plurality of second sensing electrodes TE2 disposed on the second area A2. Here, the first sensing electrode TE1 may be disposed on the first area A1 with a density larger than a density of the second sensing electrode TE2 disposed on the second area A2. Similar to FIG. 3, the densities of the first and second sensing electrodes TE1 and TE2 are with respect to a unit area in the first area A1 and the second area A2 that have a same size.

To be more specific, the plurality of first sensing electrodes TE1 may be disposed on the first area A1 to have a continuous mesh pattern. For example, the first sensing electrodes TE1 may be disposed to have a mesh pattern on the entire first area A1.

Further, the plurality of second sensing electrodes TE2 with the mesh pattern on the second area A2 may be spaced apart from each other to be electrically connected through a connection line (for example, a first connection line CL1). For example, the second sensing electrodes TE2 with the mesh pattern may be disposed on the second area A2 to be spaced apart from each other so as to correspond to (e.g., overlap) an area in which the second pixel PX2 of the display panel DP is disposed. A pair of second sensing electrodes TE2 which are adjacent to each other may be electrically connected through the first connection line CL1 with a wavy shape that is disposed between the pair of second sensing electrodes TE. The first connection line CL1 and second sensing electrodes collectively form a touch electrode for sensing touch of the second area A2. In one example, the first connection line CL1 may have a sine wave shape which is an example of the wavy shape, but this is just illustrative, and the exemplary example of the present disclosure is not limited thereto. Thus, the first connection line CL1 includes a plurality of curved portions that are connected to each other to form the wavy shape.

In the meantime, as described above, the second area A2 is an outer peripheral area (edge area) and may have a rounded shape bent along the strain direction. For example, a substrate of the touch display device DD is configured by a flexible substrate. A plurality of rigid plate patterns is disposed on the substrate to be spaced apart from each other. The second pixel PX2 and the second sensing electrode TE2 of the unit area UA of the second area A2 are disposed on the rigid plate pattern. In an area in which the second pixel PX2 and the second sensing electrode TE2 are not disposed, connection lines (for example, the first connection lines CL1) with a wavy shape (e.g., a curved shape) are disposed so that the touch display device DD may be stretched in the second area A2. Therefore, the touch display device DD may have a rounded shape which is bent along the strain direction on the second area A2.

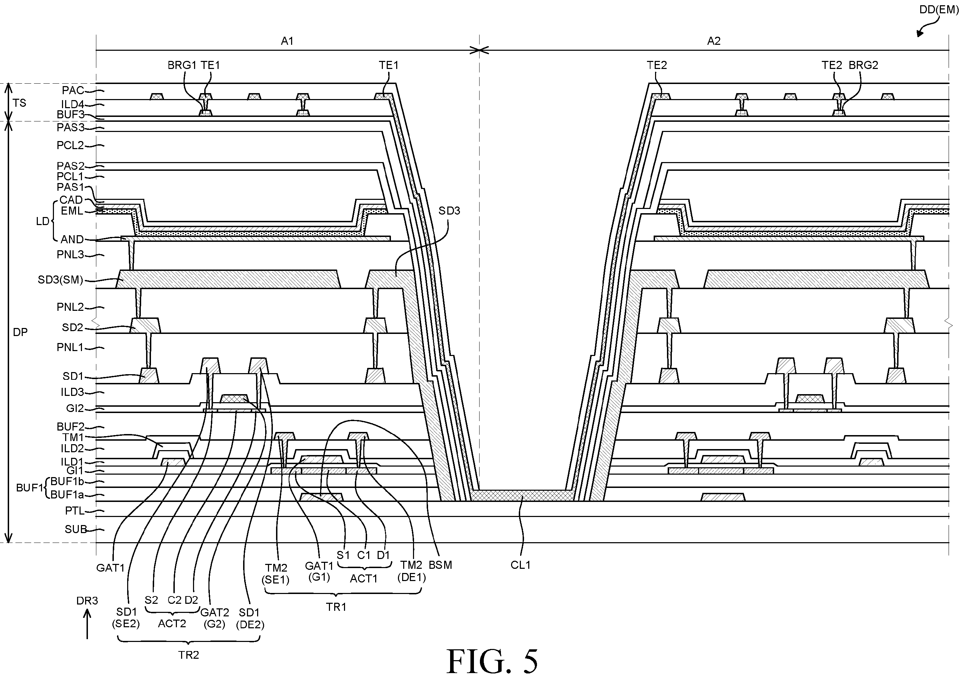

Hereinafter, a lamination relationship of the display panel DP and the touch sensor TS included in the touch display device DD will be described in detail with reference to FIG. 5.

FIG. 5 is a cross-sectional view illustrating an example taken along the line I-I' illustrated in FIG. 4 according to one example.

Referring to FIGS. 1 to 5, the touch display device DD according to the exemplary examples of the present disclosure, for example, the display module DM may include a display panel DP and a touch sensor TS on the display panel DP.

At least one transistor TR1, TR2 and a light emitting diode LD which configure the pixel may be disposed on a substrate SUB of the display panel DP. For example, at least one transistor TR1, TR2 and the light emitting diode LD disposed on the first area A1 may configure the first pixel PX1 and at least one transistor TR1, TR2 and the light emitting diode LD disposed on the second area A2 may configure the second pixel PX2.

In the meantime, a first transistor TR1, among transistors disposed on the substrate SUB, may be a polysilicon semiconductor transistor. For example, the first transistor TR1 is a p-type MOSFET transistor (PMOS transistor) including a polysilicon semiconductor layer formed by a low temperature poly-silicon (LTPS) process as an active layer (channel).

Further, a second transistor TR2, among transistors disposed on the substrate SUB, may be an oxide semiconductor transistor. For example, the second transistor TR2 may be an n-type MOSFET transistor (NMOS transistor) including an oxide semiconductor layer as an active layer (channel).

The substrate SUB is a base member of the display panel DP and may be substantially a transparent and transmissive substrate. The substrate SUB may be a flexible substrate formed of a plastic material. Here, the flexible property may be interpreted as the same meaning as bendable, unbreakable, rollable, and foldable properties.

For example, the substrate SUB may include a silicon rubber such as polydimethylsiloxane (PDMS) and elastomer such as polyurethane. Therefore, the substrate SUB may have a bendable or stretchable property. However, this is just illustrative so that the material of the substrate SUB is not limited thereto.

In the meantime, even though it is not separately illustrated in FIG. 5, a back plate and a metal plate may be further disposed below the substrate SUB.

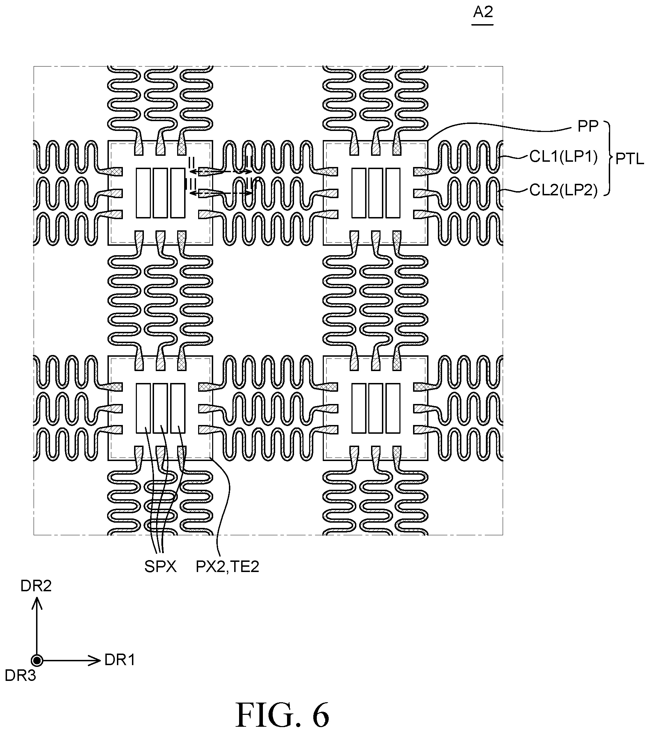

A pattern layer PTL may be disposed on the substrate SUB. The pattern layer PTL supports the pixel and connection lines and may include a plurality of plate patterns and a plurality of connection patterns disposed on the second area A2. The pattern layer PTL will be described in more detail with reference to FIGS. 6 to 8.

A shielding metal layer including at least one shielding metal pattern BSM may be disposed on the substrate SUB (or the pattern layer PTL).

The shielding metal pattern BSM included in the shielding metal layer may be formed by a single layer or a multilayer formed of any one of molybdenum (Mo), copper (Cu), titanium (Ti), aluminum (Al), chrome (Cr), gold (Au), nickel (Ni), and neodymium (Nd) or an alloy thereof.

According to an exemplary example, the shielding metal pattern BSM may be defined as a component included in the first transistor TR1. For example, the shielding metal pattern BSM may configure a lower gate electrode of the first transistor TR1.

The first buffer layer BUF1 may be disposed on the substrate SUB (or the pattern layer PTL). For example, the first buffer layer BUF1 may be disposed on the substrate SUB (or the pattern layer PTL) so as to cover the shielding metal pattern BSM.

In one exemplary example, the first buffer layer BUF1 may include a multi-buffer layer BUF1a disposed on the substrate SUB (or the pattern layer PTL) and an active buffer layer BUF1b disposed on the multi-buffer layer BUF1a.

The first transistor TR1 may be disposed on the first buffer layer BUF1. The first transistor TR1 may include a first semiconductor pattern ACT1, a first gate electrode G1, a source electrode SE1, and a drain electrode DE1. According to the exemplary example, as described above, the first transistor TR1 may further include the shielding metal pattern BSM disposed between the first buffer layer BUF1 and the substrate SUB.

A first semiconductor layer including at least one first semiconductor pattern ACT 1 may be disposed on the first buffer layer BUF1.

For example, the first semiconductor pattern ACT1 included in the first transistor TR1, of the first semiconductor layer, may be disposed on the first buffer layer BUF1. The first semiconductor pattern ACT1 may include a first region S1 (or a source electrode or a source region), a second region D1 (or a drain electrode or a drain region), and a channel region C1 therebetween. Further, as described above, the first semiconductor pattern ACT1 may include a polysilicon semiconductor layer formed by a low temperature poly-silicon (LTPS) process.

A first gate insulating layer GI1 may be disposed on the first semiconductor layer, for example, the first semiconductor pattern ACT1. For example, the first gate insulating layer GI1 is disposed so as to cover the first semiconductor layer, for example, the first semiconductor pattern ACT1 to insulate the first semiconductor pattern ACT1 of the first transistor TR1 from the first gate electrode G1.

For example, the first gate insulating layer GI1 may be configured by a single layer of silicon nitride SiNₓ or silicon oxide SiOₓ or a multilayer thereof, but is not limited thereto.

A first conductive layer GAT1 may be disposed on the first gate insulating layer GI1. The first conductive layer GAT1 may configure at least a part of an emission control line which supplies an emission control signal to the pixels, a scan line which supplies a scan signal, and a power line which supplies various power voltages. Here, when the first conductive layer GAT1 configures at least a part of the power line which supplies a power voltage, the first conductive layer GAT1 may include a material having a high conductivity, such as a metal or conductive oxide. For example, the first conductive layer GAT1 may be formed by a single layer or a multilayer including aluminum (Al), copper (Cu), or titanium (Ti). In some exemplary example, the first conductive layer GAT1 may be provided as a triple layer of titanium, aluminum, and titanium (Ti/Al/Ti) which are sequentially disposed. However, the first conductive layer GTA1 is not limited thereto and may be formed of a single layer or a multilayer formed of any one of molybdenum (Mo), copper (Cu), titanium (Ti), aluminum (Al), chrome (Cr), gold (Au), nickel (Ni), and neodymium (Nd) or an alloy thereof.

A first gate electrode G1 of the first transistor TR1 which configures at least a part of the emission control line or the scan line of the first conductive layer GAT1 may be disposed on the first gate insulating layer GI1.

The first gate electrode G1 of the first transistor TR1 may be disposed to at least partially overlap the first semiconductor pattern ACT1.

A first insulating layer ILD1 may be disposed on the first conductive layer GAT1, for example, the first gate electrode G1 of the first transistor TR1. For example, the first insulating layer ILD1 may be disposed to cover the first conductive layer GAT1, for example, the first gate electrode G1 of the first transistor TR1.

The first insulating layer ILD1 may be configured by a single layer of silicon nitride (SiNₓ) or silicon oxide (SiOₓ) or a multilayer thereof, but is not limited thereto.

A second conductive layer TM1 may be disposed on the first insulating layer ILD1. The second conductive layer TM1 includes molybdenum (Mo), copper (Cu), and titanium (Ti), and may be formed by a single layer or a multilayer.

A second insulating layer ILD2 may be disposed on the second conductive layer TM1. For example, the second insulating layer ILD2 may be disposed so as to cover the second conductive layer TM1.

The second insulating layer ILD2 may be configured by a single layer of silicon nitride SiNₓ or silicon oxide SiOₓ or a multilayer thereof, but is not limited thereto.

A third conductive layer TM2 may be disposed on the second insulating layer ILD2. The third conductive layer TM2 may include molybdenum (Mo), copper (Cu), and titanium (Ti), and may be formed by a single layer or a multilayer.

For example, a first source electrode SE1 and a first drain electrode DE1 of the first transistor TR1 of the third conductive layer TM2 may be disposed on the second insulating layer ILD2. The first source electrode SE1 of the first transistor TR1 of the third conductive layer TM2 may be in contact with a first region S1 of the first semiconductor pattern ACT 1 through a contact hole which passes through the second insulating layer ILD2, the first insulating layer ILD1, and the first gate insulating layer GI1. The first drain electrode DE1 of the first transistor TR1 of the third conductive layer TM2 may be in contact with a second region D1 of the first semiconductor pattern ACT1 through the contact hole which passes through the second insulating layer ILD2, the first insulating layer ILD1, and the first gate insulating layer GI1.

A second buffer layer BUF2 may be disposed on the third conductive layer TM2, for example, the first source electrode SE1 and the first drain electrode DE1 of the first transistor TR1. For example, the second buffer layer BUF2 may be disposed so as to cover the third conductive layer TM2.

The second buffer layer BUF2 may be configured by a single layer of silicon nitride SiNₓ or silicon oxide SiOₓ or a multilayer thereof, but is not limited thereto.

A second semiconductor layer including at least one second semiconductor pattern ACT2 may be disposed on the second buffer layer BUF2.

For example, the second semiconductor pattern ACT2 included in the second transistor TR2 of the second semiconductor layer may be disposed on the second buffer layer BUF2. The second semiconductor pattern ACT2 may include a first region S2 (or a source electrode or a source region), a second region D2 (or a drain electrode or a drain region), and a channel region C2 therebetween. Further, as described above, the second semiconductor pattern ACT2 may include an oxide semiconductor layer.

A second gate insulating layer GI2 may be disposed on the second semiconductor layer, for example, the second semiconductor pattern ACT2. The second gate insulating layer GI2 may be configured by a single layer of silicon nitride SiNₓ or silicon oxide SiOₓ or a multilayer thereof, but is not limited thereto.

A fourth conductive layer GAT2 may be disposed on the second gate insulating layer GI2. The fourth conductive layer GAT2 includes molybdenum (Mo), copper (Cu), and titanium (Ti), and may be formed by a single layer or a multilayer.

For example, the second gate electrode G2 of the second transistor TR2 which configures at least a part of the scan line of the fourth conductive layer GAT2 may be disposed on the second gate insulating layer GI2.

The second gate electrode G2 of the second transistor TR2 may be disposed to at least partially overlap the second semiconductor pattern ACT2.

A third insulating layer ILD3 may be disposed on the fourth conductive layer GAT2, for example, the second gate electrode G2 of the second transistor TR2. For example, the third insulating layer ILD3 may be disposed so as to cover the fourth conductive layer GAT2, for example, the second gate electrode G2 of the second transistor TR2.

The third insulating layer ILD3 may be configured by a single layer of silicon nitride SiNₓ or silicon oxide SiOₓ or a multilayer thereof, but is not limited thereto.

A fifth conductive layer SD1 may be disposed on the third insulating layer ILD3. The fifth conductive layer SD1 may configure at least a part of the power line which supplies a power voltage. Here, since the fifth conductive layer SD1 configures at least a part of the power line which supplies a power voltage, the fifth conductive layer SD1 may include a material having a high conductivity, such as a metal or conductive oxide. For example, the fifth conductive layer SD1 may be formed by a single layer or a multilayer including aluminum (Al), copper (Cu), or titanium (Ti). In some exemplary example, the fifth conductive layer SD1 may be provided as a triple layer of titanium, aluminum, and titanium (Ti/Al/Ti) which are sequentially disposed. However, the fifth conductive layer SD1 is not limited thereto and may be formed of a single layer or a multilayer formed of any one of molybdenum (Mo), copper (Cu), titanium (Ti), aluminum (Al), chrome (Cr), gold (Au), nickel (Ni), and neodymium (Nd) or an alloy thereof.

Further, at least a part of the fifth conductive layer SD1 may serve as a connection electrode. For example, at least a part of the fifth conductive layer SD1 may be connected to at least a part of the third conductive layer TM2 through a contact hole which passes through the third insulating layer ILD3, the second gate insulating layer GI2, and the second buffer layer BLTF2. Alternatively, at least a part of the fifth conductive layer SD1 may be in contact with at least a part of the fourth conductive layer GAT2 through a contact hole which passes through the third insulating layer ILD3.

Further, at least a part of the fifth conductive layer SD1 may configure the second source electrode SE2 and the second drain electrode DE2 of the second transistor TR2. For example, the second source electrode SE2 of the second transistor TR2 of the fifth conductive layer SD1 may be in contact with a first region S2 of the second semiconductor pattern ACT2 through a contact hole which passes through the third insulating layer ILD3 and the second gate insulating layer GI2. The second drain electrode DE2 of the second transistor TR2 of the fifth conductive layer SD1 may be in contact with a second region D2 of the second semiconductor pattern ACT2 through the contact hole which passes through the third insulating layer ILD3 and the second gate insulating layer GI2.

A first planarization layer PNL1 may be disposed on the fifth conductive layer SD1. The first planarization layer PNL1 may be an organic layer which planarizes an upper portion and protects components disposed there below. For example, the first planarization layer PNL1 may include an organic material, such as acryl resin, epoxy resin, phenolic resin, polyamide resin, or polyimide resin.

A sixth conductive layer SD2 may be disposed on the first planarization layer PNL1.

The sixth conductive layer SD2 may configure at least a part of a data line which supplies a data signal to the pixels or a power line which supplies a high potential power voltage. Here, since the sixth conductive layer SD2 configures at least a part of the power line which supplies a power voltage, the sixth conductive layer SD2 may include a material having a high conductivity, such as a metal or conductive oxide. For example, the sixth conductive layer SD2 may be formed by a single layer or a multilayer including aluminum (Al), copper (Cu), or titanium (Ti). In some exemplary example, the sixth conductive layer SD2 may be provided as a triple layer of titanium, aluminum, and titanium (Ti/Al/Ti) which are sequentially disposed. However, the sixth conductive layer SD2 is not limited thereto and may be formed of a single layer or a multilayer formed of any one of molybdenum (Mo), copper (Cu), titanium (Ti), aluminum (Al), chrome (Cr), gold (Au), nickel (Ni), and neodymium (Nd) or an alloy thereof.

Further, at least a part of the sixth conductive layer SD2 may serve as a connection electrode. For example, at least a part of the sixth conductive layer SD2 may be connected to at least a part of the fifth conductive layer SD1 through a contact hole which passes through the first planarization layer PNL1.

A second planarization layer PNL2 may be disposed on the sixth conductive layer SD2. The second planarization layer PNL2 may be an organic layer which planarizes an upper portion and protects components disposed there below. For example, the second planarization layer PNL2 may include an organic material, such as acryl resin, epoxy resin, phenolic resin, polyamide resin, or polyimide resin.

A seventh conductive layer SD3 may be disposed on the second planarization layer PNL2. The seventh conductive layer SD3 may be formed of a single layer or a multilayer formed of any one of molybdenum (Mo), copper (Cu), titanium (Ti), aluminum (Al), chrome (Cr), gold (Au), nickel (Ni), and neodymium (Nd) or an alloy thereof.

In one exemplary example, at least a part of the seventh conductive layer SD3 may serve as a shielding pattern SM. For example, in the seventh conductive layer SD3, there may be a signal interference between metal or conductive layers (for example, first to sixth conductive layers GAT1, GAT2, TM1, TM2, SD1, and SD2) located there below and the anode electrode AND of the light emitting diode LD located there above. In this case, a voltage of the anode electrode AND of the light emitting diode LD is unstable so that a display quality of the desired pixel may deteriorate. Therefore, in the case of the touch display device DD according to the exemplary examples of the present disclosure, the seventh conductive layer SD3 disposed above the second planarization layer PNL2 serves as a shielding pattern SM which shields a signal between at least a part of metal or conductive layers located there below and the anode electrode AND of the light emitting diode LD. Therefore, the display quality may be improved.

Further, at least a part of the seventh conductive layer SD3 may be connected to at least a part of the sixth conductive layer SD2 through a contact hole which passes through the second planarization layer PNL2.

A third planarization layer PNL3 may be disposed on the seventh conductive layer SD3. The third planarization layer PNL3 may be an organic layer which planarizes an upper portion and protects components disposed there below. For example, the third planarization layer PNL3 may include an organic material, such as acryl resin, epoxy resin, phenolic resin, polyamide resin, or polyimide resin.

The light emitting diode LD may be disposed on the third planarization layer PNL3. The light emitting diode LD may include an anode electrode AND (or a first electrode), a cathode electrode CAD (or a second electrode), and an emission layer EML formed therebetween.

The anode electrode AND may be disposed on the third planarization layer PNL3.

In the meantime, when the touch display device DD is a top emission type in which light emitted from the light emitting diode LD is emitted above the substrate SUB in which the light emitting diode LD is disposed, the anode electrode AND may further include a transparent conductive layer and a reflective layer on the transparent conductor layer. The transparent conductive layer may be formed of transparent conductive oxide such as ITO or IZO and the reflective layer may include silver (Ag), aluminum (Al), gold (Au), molybdenum (Mo), tungsten (W), chrome (Cr), or an alloy thereof.

A bank layer BNK is disposed so as to cover at least a part of the anode electrode AND and may open the remaining part of the anode electrode AND. For example, the bank layer BNK may be disposed to open a part corresponding to an emission area of the pixel. Therefore, a part of the anode electrode AND may be exposed by the open part of the bank layer BNK.

The bank layer BNK may include an inorganic insulating material, such as silicon nitride SiNₓ or silicon oxide SiOₓ, or an organic insulating material, such as benzocyclobutene resin, acrylic resin or imide resin, but is not limited thereto.

The emission layer EML may be disposed on the entire surface of the pixel on top surfaces of the bank layer BNK and the anode electrode AND. In the meantime, a part of the emission layer EML may be in contact with the exposed part of the anode electrode AND by the open part of the bank layer BNK.

According to the exemplary example, the emission layer EML may include a plurality of organic films.

The cathode electrode CAD may be disposed on the emission layer EML. For example, the cathode electrode CAD may be disposed on the entire surface of the pixel.

The light emitting diode LD may be formed by the anode electrode AND, the emission layer EML, and the cathode electrode CAD.

An encapsulation layer may be disposed above the light emitting diode LD. For example, the encapsulation layer may include a first inorganic encapsulation layer PAS 1, a first organic encapsulation layer PCL1 on the first inorganic encapsulation layer PAS1, a second inorganic encapsulation layer PAS2 on the first organic encapsulation layer PCL1, a second organic encapsulation layer PCL2 on the second inorganic encapsulation layer PAS2, and a third inorganic encapsulation layer PAS3 on the second organic encapsulation layer PCL2. The first inorganic encapsulation layer PAS1, the second inorganic encapsulation layer PAS2, and the third inorganic encapsulation layer PAS3 may serve to block the permeation of moisture or oxygen. For example, the first inorganic encapsulation layer PAS1, the second inorganic encapsulation layer PAS2, and the third inorganic encapsulation layer PAS3 may be formed of an inorganic material, such as silicon nitride, aluminum nitride, zirconium nitride, titanium nitride, hafnium nitride, tantalum nitride, silicon oxide, aluminum oxide, or titanium oxide. The first inorganic encapsulation layer PAS1, the second inorganic encapsulation layer PAS2, and the third inorganic encapsulation layer PAS3 may be formed by a chemical vapor deposition process or an atomic layer deposition process.

The first organic encapsulation layer PCL1 may be disposed between the first inorganic encapsulation layer PAS 1 and the second inorganic encapsulation layer PAS2 and the second organic encapsulation layer PCL2 may be disposed between the second inorganic encapsulation layer PAS2 and the third inorganic encapsulation layer PAS3. Particles may be generated during the manufacturing process. The first organic encapsulation layer PCL1 and the second organic encapsulation layer PCL2 may be formed with a thickness larger than those of the first inorganic encapsulation layer PAS 1, the second inorganic encapsulation layer PAS2, and the third inorganic encapsulation layer PAS3 to adsorb and/or block the particles. The first organic encapsulation layer PCL1 and the second organic encapsulation layer PCL2 may be formed of an organic material, such as silicon oxy carbon SiOCz acryl or epoxy resin. The first organic encapsulation layer PCL1 and the second organic encapsulation layer PCL2 may be formed by a coating process, such as an inkjet coating process or a slit coating process.

A touch sensor TS may be disposed on the display panel DP. For example, the touch sensor TS may include a third buffer layer BUF3, a fourth insulating layer ILD4, and a protection layer PAC disposed on the encapsulation layer of the display panel DP.

The third buffer layer BUF3 of the touch sensor TS may be disposed on the encapsulation layer of the display panel DP.

When the touch sensor TS is formed on the display panel DP, chemicals (developer or etchant, etc.) used for the process, moisture from the outside, or the like may be generated. As the touch sensor TS is disposed on the third buffer layer BUF3, the chemicals or moisture may be suppressed from permeating into the emission layer EML including an organic material during the manufacturing process of the touch sensor TS. By doing this, the third buffer layer BUF3 may suppress the damage of the emission layer EML which is vulnerable to the chemicals or the moisture.

The third buffer layer BUF3 may include an organic insulating material which is formed at a temperature lower than a predetermined temperature (for example, 100° C) to suppress the damage of the emission layer EML including an organic material which is vulnerable to a high temperature. The organic insulating material has a low permittivity of 1 to 3. For example, the third buffer layer BUF3 may include an acrylic, epoxy, or siloxane-based material. In the meantime, as the touch display device DD is bent, the encapsulation layer of the display panel DP may be damaged and the metal (for example, the plurality of sensing electrodes TE1 and TE2 and/or the plurality of bridge electrodes BRG1 and BRG2) located on the third buffer layer BLTF3 may be broken. Here, even though the touch display device DD is bent, the third buffer layer BUF3 which is an organic insulating material and has a planarization performance may suppress the damage of the encapsulation layer of the display panel DP and/or the breakage of the metal (for example, the plurality of sensing electrodes TE1 and TE2 and/or the plurality of bridge electrodes BRG1 and BRG2) which configures the touch sensor TS.

A plurality of sensing electrodes TE1 and TE2 and bridge electrodes BRG1 and BRG2 disposed on different layers may be disposed on the third buffer layer BUF3.

For example, the plurality of bridge electrodes BRG1 and BRG2 may be disposed on the third buffer layer BUF3. For example, the first bridge electrodes BRG1 may be disposed on the third buffer layer BUF3 of the first area A1 and the second bridge electrodes BRG2 may be disposed on the third buffer layer BUF3 of the second area A2.

A fourth insulating layer ILD4 may be disposed on the bridge electrodes BRG1 and BRG2. The fourth insulating layer ILD4 is disposed between the plurality of sensing electrodes TE1 and TE2 and the bridge electrodes BRG1 and BRG2 to insulate the plurality of sensing electrodes TE1 and TE2 and the bridge electrodes BRG1 and BRG2.

The fourth insulating layer ILD4 may be configured by a single layer of silicon nitride SiNₓ or silicon oxide SiOₓ or a multilayer thereof, but is not limited thereto.

The plurality of sensing electrodes TE1 and TE2 may be disposed on the fourth insulating layer ILD4. For example, the first sensing electrodes TE1 may be disposed on the fourth insulating layer ILD4 of the first area A1 and the second sensing electrodes TE2 may be disposed on the fourth insulating layer ILD4 of the second area A2.

According to the exemplary example, the first sensing electrode TE1 may be electrically connected to the first bridge electrode BRG1 through a contact hole which passes through the fourth insulating layer ILD4, on the first area A1. Further, the second sensing electrode TE2 may be electrically connected to the second bridge electrode BRG2 through a contact hole which passes through the fourth insulating layer ILD4, on the second area A2.

A protection layer PAC may be disposed on the plurality of sensing electrodes TE1 and TE2. For example, the protection layer PAC may be disposed on the fourth insulating layer ILD4 so as to cover the plurality of sensing electrodes TE1 and TE2.

The protection layer PAC may be an organic insulating film, but is not limited thereto. For example, the protection layer PAC may include an inorganic material, such as silicon nitride (SiNₓ) and/or silicon oxide (SiOₓ).

In the meantime, as described with reference to FIG. 4, the first connection line CL1 may be disposed on the second area A2 to connect second sensing electrodes TE2 which are adjacent to each other, among the plurality of second sensing electrodes TE2.

For example, as illustrated in FIG. 5, at a boundary between the first area A1 and the second area A2, at least a part of the first sensing electrode TE1 disposed in the first area A1 extends to the second area A2 to configure the first connection line CL1. The first connection line CL1 may be electrically connected to the second sensing electrode TE2 of the second area A2. For example, at least a part of the first sensing electrode TE1 is disposed so as to be in contact a top surface and a side surface of the fourth insulating layer ILD4 and a side surface of the third buffer layer BLTF3 disposed in the first area A1 to extend to the top surface of the pattern layer PTL of the second area A2 to be electrically connected to the first connection line CL1. The first connection line CL1 is disposed to be in contact with a side surface of the third buffer layer BLTF3 and the top surface and the side surface of the fourth insulating layer ILD4 disposed in the second area A2 to be electrically connected to the second sensing electrode TE2 of the second area A2. Therefore, at the boundary between the first area A1 and the second area A2, the first sensing electrodes TE1 disposed in the first area A1 and the second sensing electrodes TE2 disposed in the second area A2 may be electrically connected to each other through the first connection line CL1.

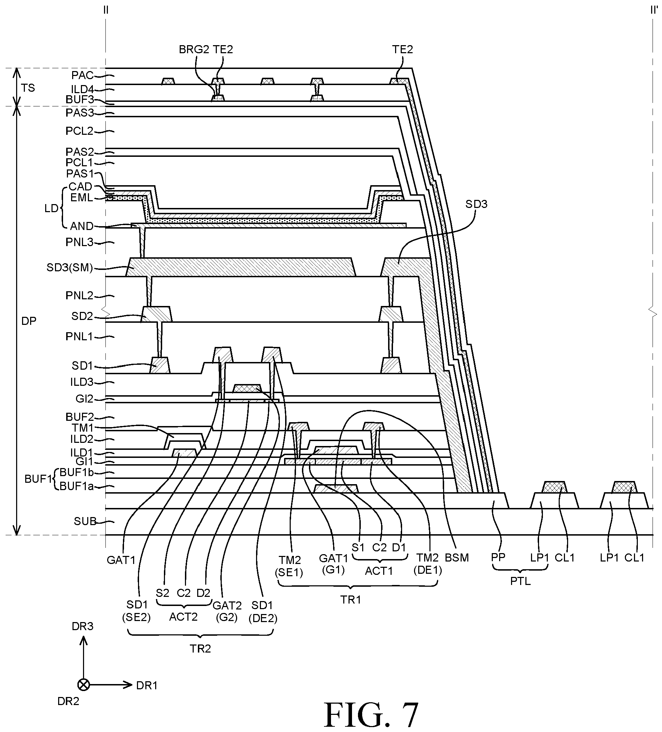

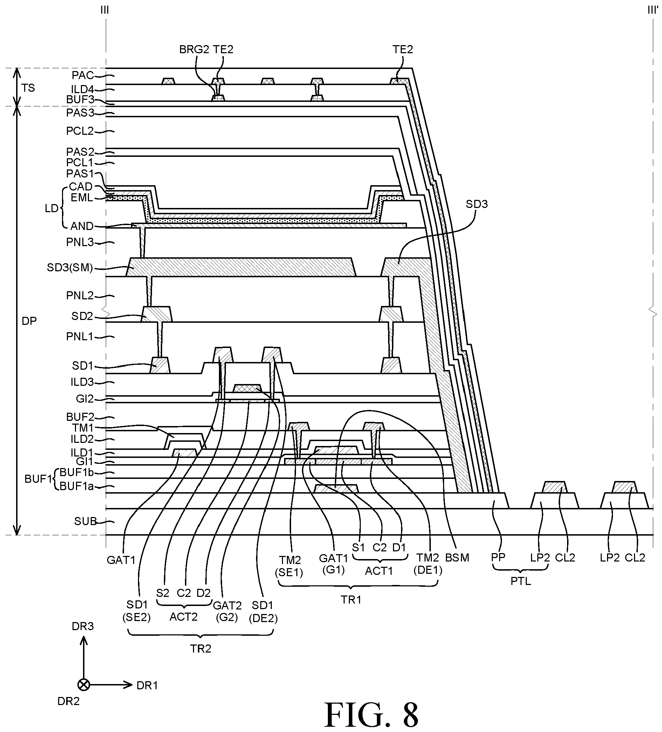

FIG. 6 is an enlarged view illustrating an example enlarging a part of a second area of a touch display device of FIG. 1 according to one example. FIG. 7 is a cross-sectional view illustrating an example taken along the line II-II' of FIG. 6 according to one example. FIG. 8 is a cross-sectional view illustrating an example taken along the line III-III' of FIG. 6 according to one example.

In order to avoid redundant descriptions, contents which do not overlap the description with reference to FIGS. 1 to 5 will be mainly described. A part which is not specifically described follows the above-described exemplary example and the same reference numeral denotes the same component and the like reference numeral denotes the like component.

Referring to FIGS. 1 to 6, a touch display device DD according to the exemplary examples of the present disclosure includes a display panel DP and a touch sensor TS disposed on the display panel DP. The display panel DP includes a substrate SUB, a pattern layer PTL, and a plurality of pixels PX1 and PX2 and the touch sensor TS may include a plurality of sensing electrodes TE1 and TE2.

As described above, the substrate SUB is a base member of the display panel DP and is a substrate for supporting and protecting various components of the touch display device DD.

The substrate SUB is a flexible substrate so as to be reversibly expanded and contracted. Therefore, the substrate SUB may be referred to as a stretchable substrate, an elastic substrate, a stretching substrate, or a flexible substrate. Further, a modulus of elasticity of the substrate SUB may be several MPa to several hundreds of MPa. Further, a ductile breaking rate of the substrate SUB may be 100% or higher. Here, the ductile breaking rate refers to a stretching rate at a timing when an object to be stretched is broken or cracked.

The pattern layer PTL may be disposed on the substrate SUB. According to the exemplary example, the pattern layer PTL may include a plurality of plate patterns PP, a plurality of first connection patterns LP1, and a plurality of second connection patterns LP2 disposed on the second area A2.

The plurality of plate patterns PP may be disposed on the second area A2. For example, the plate patterns PP may be disposed above the second area A2 of the substrate SUB. Further, as illustrated in FIG. 6, the plurality of second pixels PX2 including a plurality of sub pixels SPX, respectively, and a second sensing electrode TE2 may be disposed and/or formed on the plate patterns PP.

The plate patterns PP may be spaced apart from each other to be disposed on the second area A2 of the substrate SUB. For example, as illustrated in FIG. 6, the plate patterns PP may be disposed on the second area A2 of the substrate SUB in a matrix, but this is just illustrative, but the exemplary example of the present disclosure is not limited thereto.

The connection patterns LP1 and LP2 are disposed between the adjacent plate patterns PP to connect the plate patterns and may be disposed on the second area A2. The connection patterns LP1 and LP2 may be divided into the first connection patterns LP1 and the second connection patterns LP2. In one example, each first connection pattern LP1 is between a pair of plate patterns PP and electrically connects together the pair of plate patterns PP. Similarly, each second connection pattern LP2 is between a pair of plate patterns PP and electrically connects together the pair of plate patterns PP. As shown in FIG. 6, the pair of plate patterns PP that are connected together by at least one second connection pattern LP2 is also connected together by a first connection pattern LP1.

The plurality of first connection patterns LP1 may be disposed on the second area A2. For example, the first connection patterns LP1 may be disposed above the second area A2 of the substrate SUB.

The first connection patterns LP1 may be patterns which are disposed on the second area A2 and connect adj acent plate patterns PP. According to the exemplary example, the first connection pattern LP1 may be referred to as a first line pattern. That is, at least one first connection pattern LP1 may be disposed between the plate patterns PP.

In the exemplary example, each of the first connection patterns LP1 may have a wavy shape. For example, the first connection pattern LP1 may have a sine wave shape. However, this is just illustrative, so that the shape of the first connection pattern LP1 is not limited thereto. For example, each of the first connection patterns LP1 may have a zigzag shape. As another example, each of the first connection patterns LP1 may have various shapes, such as a plurality of rhombic substrates being connected and extending at vertices. As described above, the number and the shape of the plurality of first connection patterns LP1 illustrated in FIG. 6 are illustrative and the number and the shape of the first connection patterns LP1 may vary depending on the design.

Further, the first connection line CL1 may be disposed above each of the first connection patterns LP1.

The plurality of second connection patterns LP2 may be disposed on the second area A2. For example, the second connection patterns LP2 may be disposed above the second area A2 of the substrate SUB.

The second connection patterns LP2 may be patterns which are disposed on the second area A2 and connect adjacent plate patterns PP, similar to the first connection pattern LP1. According to the exemplary example, the second connection pattern LP2 may be referred to as a second line pattern. That is, at least one second connection pattern LP2 may be disposed between the plate patterns PP.

In one exemplary example, the number of second connection patterns LP2 disposed between the plate patterns PP may be larger than the number of first connection patterns LP1 disposed between the plate patterns PP. For example, as illustrated in FIG. 6, one first connection pattern LP1 may be disposed between the plate patterns PP and two second connection patterns LP2 may be disposed between the plate patterns PP, but the exemplary example of the present disclosure is not limited thereto. For example, two or more first connection patterns LP1 may be disposed between the plate patterns PP and/or one or three or more second connection patterns LP2 may be disposed between the plate patterns PP.

In the exemplary example, each of the second connection patterns LP2 may have a wavy shape. For example, the second connection pattern LP2 may have a sine wave shape. However, this is just illustrative, so that the shape of the second connection pattern LP2 is not limited thereto. For example, each of the second connection patterns LP2 may have a zigzag shape. As another example, each of the second connection patterns LP2 may have various shapes, such as a plurality of rhombic substrates being connected and extending at vertices. As described above, the number and the shape of the second connection patterns LP2 illustrated in FIG. 6 are illustrative and the number and the shape of the second connection patterns LP2 may vary depending on the design.

Further, the second connection line CL2 may be disposed above each of the second connection patterns LP2.

In the exemplary example, the pattern layer PTL, for example, the plate pattern PP, the first connection pattern LP1, and the second connection pattern LP2 may be rigid patterns, respectively. For example, each of the plate pattern PP, the first connection pattern LP1, and the second connection pattern LP2 may be more rigid than the substrate SUB. Accordingly, moduli of elasticity of the plate pattern PP, the first connection pattern LP1, and the second connection pattern LP2 may be higher than a modulus of elasticity of the substrate SUB. The modulus of elasticity is a parameter representing a rate of deformation against the stress applied to the substrate and the higher the modulus of elasticity, the higher the hardness. Therefore, the plate pattern PP, the first connection pattern LP1, and the second connection pattern LP2 may also be referred to as first to third rigid patterns. For example, moduli of elasticity of the plate pattern PP, the first connection pattern LP1, and the second connection pattern LP2 may be 1000 times higher than the modulus of elasticity of the substrate SUB, but this is illustrative and the exemplary example of the present disclosure is not limited thereto.

In one exemplary example, the pattern layer PTL, for example, each of the plate pattern PP, the first connection pattern LP1, and the second connection pattern LP2 may include a plastic material having a flexibility lower than that of the substrate SUB. For example, the plate pattern PP, the first connection pattern LP1, and the second connection pattern LP2 may include at least one material of polyimide (PI), polyacrylate, and polyacetate.

According to the exemplary example, the plate pattern PP, the first connection pattern LP1, and the second connection pattern LP2 may be formed of the same material, but are not limited thereto and may be formed of different materials. When the plate pattern PP, the first connection pattern LP1, and the second connection pattern LP2 are formed of the same material, the plate pattern PP, the first connection pattern LP1, and the second connection pattern LP2 may be integrally formed.

As illustrated in FIG. 6, on the second area A2, a first connection line CL1 which extends along the first direction DR1 or the second direction DR2 and is disposed on the first connection pattern LP1 and a second connection line CL2 which extends along the first direction DR1 or the second direction DR2 and is disposed on the second connection pattern LP2 may be formed.

In one exemplary example, the first connection line CL1 may electrically connect sensing electrodes disposed on the adjacent plate patterns PP, for example, the second sensing electrodes TE2.

For example, further referring to FIG. 7, the second sensing electrode TE2 included in the touch sensor TS may be disposed on the plate pattern PP of the pattern layer PTL. Here, at least a part of the second sensing electrode TE2 may be disposed and extend so as to be in contact with a top surface and a side surface of the fourth insulating layer ILD4 and a side surface of the third buffer layer BUF3 disposed on the plate pattern PP. Therefore, at least a part of the second sensing electrode TE2 may be electrically connected to the first connection line CL1 disposed on the first connection pattern LP1. Accordingly, the first connection line CL1 disposed on the first connection pattern LP1 may electrically connect the second sensing electrodes TE2 disposed on the adjacent plate patterns PP. That is, the first connection line CL1 may be utilized as a touch electrode in the second area A2 together with the second sensing electrode TE2.

Further, in one exemplary example, the second connection line CL2 may electrically connect pixels disposed on the adjacent plate patterns PP, for example, the second pixels PX2.

For example, further referring to FIG. 8, the second pixel PX2 included in the display panel DP, for example, at least one transistor TR1, TR2 and the light emitting diode LD may be disposed on the plate pattern PP of the pattern layer PTL. Here, at least a part of the seventh conductive layer SD3 included in the second pixel PX2 is disposed and extends to be in contact with the top surface and the side surface of the second planarization layer PNL2, the side surface of the first planarization layer PNL1, the side surface of the third insulating layer ILD3, the side surface of the second gate insulating layer GI2, the side surface of the second insulating layer ILD2, the side surface of the first insulating layer ILD1, the side surface of the first gate insulating layer GI1, and the side surface of the first buffer layer BUF1 disposed on the plate pattern PP to be electrically connected to the second connection line CL2 disposed on the second connection pattern LP2. Accordingly, the second connection line CL2 disposed on the second connection pattern LP2 may electrically connect the second pixels PX2 disposed on the adjacent plate patterns PP.

In one exemplary example, the second connection line CL2 configured to connect the second pixels PX2 may include various wiring lines, such as a gate line (for example, a scan signal line or an emission control line), a data line, a high potential voltage line, a low potential voltage line, and an initialization voltage line.

The first connection line CL1 and the second connection line CL2 may be formed of a metal material, such as copper (Cu), aluminum (Al), titanium (Ti), and molybdenum or a laminated structure of metal materials, such as copper/molybdenum-titanium (Cu/Mo/Ti) or titanium/aluminum/titanium (Ti/Al/Ti), but are not limited thereto.

In one exemplary example, the first connection line CL1 may be simultaneously formed with the sensing electrode of the touch sensor TS, for example, the second sensing electrode TE2, by the same process. In this case, the first connection line CL1 and the second sensing electrode TE2 may include the same material.

In one exemplary example, the second connection line CL2 may be simultaneously formed with the seventh conductive layer SD3 of the display panel DP by the same process. In this case, the second connection line CL2 and the seventh conductive layer SD3 may include the same material.

According to the exemplary example, as illustrated in FIGS. 7 and 8, the first connection line CL1 and the second connection line CL2 may be disposed on the same plane. For example, the first connection line CL1 may be directly disposed on the first connection pattern LP1 and the second connection line CL2 may be directly disposed on the second connection pattern LP2 disposed on the same layer as the first connection pattern LP1. That is, the first connection line CL1 and the second connection line CL2 may be horizontally deposited. Therefore, the touch display device DD may ensure the stretchability on the second area A2.

As described above, according to the exemplary examples of the present disclosure, the touch display device includes a display panel and a touch sensor disposed on the display panel and may include a first area which is a center area and a second area which is an outer peripheral area (edge area) surrounding the first area. Further, the touch display device may include a plurality of plate patterns which is disposed on the second area and includes a sensing electrode disposed thereon and a connection pattern configured to connect adjacent plate patterns and includes a connection line disposed thereon. The connection line connects sensing electrodes formed on the plate pattern. Therefore, the connection line disposed in the outer peripheral area may be utilized as a part of the touch electrode.

According to the exemplary examples of the present disclosure, in the touch display device, the second pixel disposed in the second area may be disposed with a pixel density lower than the first pixel disposed in the first area. Therefore, in the second area which is an outer peripheral area, the touch display device can be modified so that the second area which is an outer peripheral area may be designed to have a rounded shape.

The exemplary examples of the present disclosure can also be described as follows:
According to an aspect of the present disclosure, a touch display device which includes a first area disposed in a center and a second area surrounding the first area, includes: a display panel which includes a substrate, a plurality of first pixels disposed in the first area of the substrate, and a plurality of second pixels disposed in the second area of the substrate; and a touch sensor which is disposed on the display panel and includes a plurality of first sensing electrodes disposed in the first area and a plurality of second sensing electrodes disposed in the second area. The plurality of first pixels and the plurality of second pixels are disposed with different densities, and the plurality of first sensing electrodes and the plurality of second sensing electrodes may be disposed with different densities.

The first pixels may be disposed in the first area with a first pixel density and the second pixels may be disposed in the second area with a second pixel density which is smaller than the first pixel density.

The first sensing electrodes may be disposed with a density larger than that of the second sensing electrodes.

Each of the second sensing electrodes may be disposed so as to correspond to an area in which each of the second pixels may be disposed.

The touch sensor may further include a connection line configured to connect second sensing electrodes which is adj acent to each other, among the second sensing electrodes.

The touch display device may further comprise a pattern layer which includes a plurality of plate patterns, a plurality of first connection patterns, and a plurality of second connection patterns disposed on the second area of the substrate and includes an insulating material.

The plurality of plate patterns may be disposed to be spaced apart from each other, the first connection patterns connect plate patterns which is adjacent to each other, among the plurality of plate patterns, and the second connection patterns connect plate patterns which is adjacent to each other, among the plurality of plate patterns.

The touch display device may further comprise a plurality of second connection lines disposed on the second connection patterns, the second pixels may be disposed above the plurality of plate patterns, respectively, and the second connection lines electrically connect second pixels which is adjacent to each other, among the second pixels.

The touch display device may further comprise a plurality of first connection lines disposed on the first connection patterns, the second sensing electrodes may be disposed above the second pixels, respectively, and the first connection lines electrically connect second sensing electrodes which is adjacent to each other, among the second sensing electrodes.

A number of first connection patterns disposed between the adjacent plate patterns, among the plurality of plate patterns, may be smaller than a number of second connection patterns disposed between the adjacent plate patterns.

Each of the first connection patterns and the second connection patterns may have a wavy shape.

The display panel includes a first buffer layer disposed on the pattern layer, a first semiconductor layer which is disposed on the first buffer layer and includes a first semiconductor pattern of a first transistor, a first gate insulating layer disposed on the first semiconductor layer; a first conductive layer which is disposed on the first gate insulating layer and includes a first gate electrode of the first transistor; a first insulating layer disposed on the first conductive layer; a second conductive layer disposed on the first insulating layer; a second insulating layer disposed on the second conductive layer; and a third conductive layer which is disposed on the second insulating layer and includes a first source electrode and a first drain electrode of the first transistor.

The display panel may further include a second buffer layer disposed on the third conductive layer; a second semiconductor layer which is disposed on the second buffer layer and includes a second semiconductor pattern of a second transistor; a second gate insulating layer disposed on the second semiconductor layer; a fourth conductive layer which is disposed on the second gate insulating layer and includes a second gate electrode of the second transistor; a third insulating layer disposed on the fourth conductive layer; and a fifth conductive layer which is disposed on the third insulating layer and includes a second source electrode and a second drain electrode of the second transistor.

The display panel may further include a first planarization layer disposed on the fifth conductive layer; a sixth conductive layer disposed on the first planarization layer; a second planarization layer disposed on the sixth conductive layer; and a seventh conductive layer disposed on the second planarization layer.

The seventh conductive layer may be disposed to extend from the first area to the second connection pattern disposed on the second area.

The display panel may further include a light emitting diode disposed on the seventh conductive layer; and an encapsulation layer disposed on the light emitting diode, and the encapsulation layer includes a first inorganic encapsulation layer disposed on the light emitting diode; a first organic encapsulation layer disposed on the first inorganic encapsulation layer; a second inorganic encapsulation layer disposed on the first organic encapsulation layer; a second organic encapsulation layer disposed on the second inorganic encapsulation layer; and a third inorganic encapsulation layer disposed on the second organic encapsulation layer.

The touch sensor may include a third buffer layer disposed on the display panel; a plurality of bridge electrodes disposed on the third buffer layer; a fourth insulating layer disposed on the plurality of bridge electrodes; a plurality of sensing electrodes disposed on the fourth insulating layer; and a protection layer disposed on the plurality of sensing electrodes.

The plurality of bridge electrodes may include a first bridge electrode disposed on the first area and a second bridge electrode disposed on the second area, the plurality of sensing electrodes includes a first sensing electrode disposed on the first area and a second sensing electrode disposed on the second area, in the first area, the first sensing electrode may be electrically connected to the first bridge electrode through a contact hole which passes through the fourth insulating layer, and in the second area, the second sensing electrode may be electrically connected to the second bridge electrode through the contact hole which passes through the fourth insulating layer.

A first sensing electrode disposed on the first area, among the plurality of sensing electrodes, may be disposed to extend from the first area to the second connection pattern disposed on the second area.

Further examples are set out in the examples below:
1. A touch display device, comprising:
   a display panel including a substrate having a first area in a center of the substrate and a second area that surrounds the first area, a plurality of first pixels in the first area of the substrate, and a plurality of second pixels in the second area of the substrate; and
   a touch sensor on the display panel, the touch sensor configured to sense touch and includes a plurality of first sensing electrodes in the first area and a plurality of second sensing electrodes in the second area,
   wherein a density of the plurality of first pixels in the first area is different from a density of the plurality of second pixels in the second area, and a density of the plurality of first sensing electrodes in the first area is different from a density of the plurality of second sensing electrodes in the second area.
2. The touch display device according to clause 1, wherein the density of the plurality of first pixels in the first area is greater than the density of the plurality of second pixels in the second area.
3. The touch display device according to clause 2, wherein the density of the plurality of first sensing electrodes in the first area is greater than the density of the plurality of second sensing electrodes in the second area.
4. The touch display device according to any one of clauses 1-3, wherein each of the plurality of second sensing electrodes overlaps an area where a second pixel from the plurality of second pixels is disposed.
5. The touch display device according to any one of the preceding clauses, wherein the touch sensor further comprises:
   a connection line in the second area, the connection line connecting together second sensing electrodes from the plurality of second sensing electrodes that are adjacent to each other in the second area.
6. The touch display device according to any one of the preceding clauses, further comprising:
   a pattern layer including an insulating material, the pattern layer including a plurality of plate patterns in the second area of the substrate, a plurality of first connection patterns on the second area of the substrate, and a plurality of second connection patterns on the second area of the substrate.
7. The touch display device according to clause 6, wherein the plurality of plate patterns are spaced apart from each other, each of the plurality of first connection patterns connects together a corresponding pair of plate patterns from the plurality of plate patterns that are adj acent to each other, and each of the plurality of second connection patterns connects together a corresponding pair of plate patterns from the plurality of plate patterns that are also connected together by one of the plurality of first connection patterns.
8. The touch display device according to clause 6, further comprising:
   a plurality of second connection lines on the plurality of second connection patterns, wherein the plurality of second pixels are over the plurality of plate patterns, and the plurality of second connection lines electrically connect a pair of second pixels from the plurality of second pixels that are adjacent to each other.
9. The touch display device according to clause 8, further comprising:
   a plurality of first connection lines on the plurality of first connection patterns,
   wherein the plurality of second sensing electrodes are over the plurality of second pixels, and
   the plurality of first connection lines electrically connect a pair of second sensing electrodes from the plurality of second sensing electrodes that are adjacent to each other.
10. The touch display device according to clause 7, wherein a number of first connection patterns between the corresponding pair of plate patterns is less than a number of second connection patterns between the corresponding pair of plate patterns.
11. The touch display device according to clause 6, wherein each of the plurality of first connection patterns and each of the plurality of second connection patterns has a wavy shape.
12. The touch display device according to clause 6, wherein the display panel further comprises:
   a first buffer layer on the pattern layer;
   a first semiconductor layer on the first buffer layer, the first semiconductor layer including a first semiconductor pattern of a first transistor;
   a first gate insulating layer on the first semiconductor layer;
   a first conductive layer on the first gate insulating layer, the first conductive layer including a first gate electrode of the first transistor;
   a first insulating layer on the first conductive layer;
   a second conductive layer on the first insulating layer;
   a second insulating layer on the second conductive layer; and
   a third conductive layer on the second insulating layer, the third conductive layer
   including a first source electrode and a first drain electrode of the first transistor.
13. The touch display device according to clause 12, wherein the display panel further comprises:
   a second buffer layer on the third conductive layer;
   a second semiconductor layer on the second buffer layer, the second semiconductor layer including a second semiconductor pattern of a second transistor;
   a second gate insulating layer on the second semiconductor layer;
   a fourth conductive layer on the second gate insulating layer, the fourth conductive layer including a second gate electrode of the second transistor;
   a third insulating layer on the fourth conductive layer; and
   a fifth conductive layer on the third insulating layer, the fifth conductive layer including a second source electrode and a second drain electrode of the second transistor.
14. The touch display device according to clause 13, wherein the display panel further includes:
   a first planarization layer on the fifth conductive layer;
   a sixth conductive layer on the first planarization layer;
   a second planarization layer on the sixth conductive layer; and
   a seventh conductive layer on the second planarization layer.
15. The touch display device according to clause 14, wherein the seventh conductive layer extends from the first area to a second connection pattern from the plurality of second connection patterns on the second area.
16. The touch display device according to clause 14, wherein the display panel further includes:
   a light emitting diode on the seventh conductive layer; and
   an encapsulation layer on the light emitting diode, the encapsulation layer including:
      a first inorganic encapsulation layer on the light emitting diode;
      a first organic encapsulation layer on the first inorganic encapsulation layer;
      a second inorganic encapsulation layer on the first organic encapsulation layer;
      a second organic encapsulation layer on the second inorganic encapsulation layer; and
      a third inorganic encapsulation layer on the second organic encapsulation layer.
17. The touch display device according to clause 6, wherein the touch sensor comprises:
   a third buffer layer on the display panel;
   a plurality of bridge electrodes on the third buffer layer;
   a fourth insulating layer on the plurality of bridge electrodes, wherein the plurality of first sensing electrodes and the plurality of second sensing electrodes are on the fourth insulating layer; and
   a protection layer on the plurality of first sensing electrodes and the plurality of second sensing electrodes.
18. The touch display device according to clause 17, wherein the plurality of bridge electrodes include a first bridge electrode on the first area and a second bridge electrode on the second area,
   wherein in the first area, a first sensing electrode from the plurality of first sensing electrodes is electrically connected to the first bridge electrode through a first contact hole that passes through the fourth insulating layer, and in the second area, a second sensing electrode from the plurality of second sensing electrodes is electrically connected to the second bridge electrode through a second contact hole that passes through the fourth insulating layer.
19. The touch display device according to clause 17, wherein a first sensing electrode from the plurality of first sensing electrodes in the first area extends from the first area to a second connection pattern from the plurality of second connection patterns on the second area.
20. A touch display device, comprising:
   a display panel comprising a first area of the display panel and a second area corresponding to a curved edge of the display panel that surrounds the first area, a plurality of first pixels in the first area of the display panel that are configured to emit light, and a plurality of second pixels in the second area of the display panel that are configured to emit light; and
   a touch sensor on the display panel, the touch sensor including:
      a plurality of first sensing electrodes in the first area, the plurality of first sensing electrodes configured to sense touch of the first area;
      a plurality of second sensing electrodes that are spaced apart from each other in the second area, the plurality of second sensing electrodes configured to sense touch of the second area; and
      a plurality of connection lines in the second area, at least one connection line from the plurality of connection lines between a pair of second sensing electrodes from the plurality of second sensing electrodes and electrically connecting together the pair of second sensing electrodes.
21. The touch display device of clause 20, wherein the plurality of second sensing electrodes and the plurality of connection lines configured to sense touch of the second area of the display panel.
22. The touch display device of clause 20 or 21, wherein a density of the plurality of first pixels in the first area is greater than a density of the plurality of second pixels in the second area.
23. The touch display device according to clause 20, wherein a density of the plurality of first sensing electrodes in the first area is greater than a density of the second sensing electrodes in the second area.
24. The touch display device of any one of clauses 20-23, wherein each of the plurality of second sensing electrodes overlaps a corresponding second pixel from the plurality of second pixels.
25. The touch display device of any one of clauses 20-24, wherein the plurality of connection lines includes at least one connection line that is between a second sensing electrode from the plurality of second sensing electrodes and a first sensing electrode from the plurality of first sensing electrodes and electrically connects the second sensing electrode and the first sensing electrode.
26. The touch display device of any one of clauses 20-25, wherein each of the plurality of connection lines comprises a plurality of curved portions.

Although the exemplary examples of the present disclosure have been described in detail with reference to the accompanying drawings, the present disclosure is not limited thereto and may be embodied in many different forms without departing from the technical concept of the present disclosure. Therefore, the exemplary examples of the present disclosure are provided for illustrative purposes only but not intended to limit the technical concept of the present disclosure. The scope of the technical concept of the present disclosure is not limited thereto. Therefore, it should be understood that the above-described exemplary examples are illustrative in all aspects and do not limit the present disclosure. All the technical concepts in the equivalent scope of the present disclosure should be construed as falling within the scope of the present disclosure.

## Claims

1. A touch display device, comprising:
a display panel including a substrate having a first area in a center of the substrate and a second area that surrounds the first area, a plurality of first pixels in the first area of the substrate, and a plurality of second pixels in the second area of the substrate; and
a touch sensor on the display panel, the touch sensor configured to sense touch and includes a plurality of first sensing electrodes in the first area and a plurality of second sensing electrodes in the second area,
wherein a density of the plurality of first pixels in the first area is different from a density of the plurality of second pixels in the second area, and a density of the plurality of first sensing electrodes in the first area is different from a density of the plurality of second sensing electrodes in the second area.

2. The touch display device according to claim 1, wherein the density of the plurality of first pixels in the first area is greater than the density of the plurality of second pixels in the second area; and optionally
wherein the density of the plurality of first sensing electrodes in the first area is greater than the density of the plurality of second sensing electrodes in the second area.

3. The touch display device according to any one of claims 1-2, wherein each of the plurality of second sensing electrodes overlaps an area where a second pixel from the plurality of second pixels is disposed.

4. The touch display device according to claim 1, wherein the touch sensor further comprises:
a connection line in the second area, the connection line connecting together second sensing electrodes from the plurality of second sensing electrodes that are adjacent to each other in the second area.

5. The touch display device according to claim 1, further comprising:
a pattern layer including an insulating material, the pattern layer including a plurality of plate patterns in the second area of the substrate, a plurality of first connection patterns on the second area of the substrate, and a plurality of second connection patterns on the second area of the substrate.

6. The touch display device according to claim 5, wherein the plurality of plate patterns are spaced apart from each other, each of the plurality of first connection patterns connects together a corresponding pair of plate patterns from the plurality of plate patterns that are adjacent to each other, and each of the plurality of second connection patterns connects together a corresponding pair of plate patterns from the plurality of plate patterns that are also connected together by one of the plurality of first connection patterns.

7. The touch display device according to claim 5, further comprising:
a plurality of second connection lines on the plurality of second connection patterns, wherein the plurality of second pixels are over the plurality of plate patterns, and the plurality of second connection lines electrically connect a pair of second pixels from the plurality of second pixels that are adjacent to each other; and optionally
further comprising:
a plurality of first connection lines on the plurality of first connection patterns,
wherein the plurality of second sensing electrodes are over the plurality of second pixels, and the plurality of first connection lines electrically connect a pair of second sensing electrodes from the plurality of second sensing electrodes that are adjacent to each other.

8. The touch display device according to claim 6, wherein a number of first connection patterns between the corresponding pair of plate patterns is less than a number of second connection patterns between the corresponding pair of plate patterns.

9. The touch display device according to claim 5, wherein each of the plurality of first connection patterns and each of the plurality of second connection patterns has a wavy shape; or optionally
wherein the display panel further comprises:
a first buffer layer on the pattern layer;
a first semiconductor layer on the first buffer layer, the first semiconductor layer including a first semiconductor pattern of a first transistor;
a first gate insulating layer on the first semiconductor layer;
a first conductive layer on the first gate insulating layer, the first conductive layer including a first gate electrode of the first transistor;
a first insulating layer on the first conductive layer;
a second conductive layer on the first insulating layer;
a second insulating layer on the second conductive layer; and
a third conductive layer on the second insulating layer, the third conductive layer including a first source electrode and a first drain electrode of the first transistor.

10. The touch display device according to claim 9, wherein the display panel further comprises:
a second buffer layer on the third conductive layer;
a second semiconductor layer on the second buffer layer, the second semiconductor layer including a second semiconductor pattern of a second transistor;
a second gate insulating layer on the second semiconductor layer;
a fourth conductive layer on the second gate insulating layer, the fourth conductive layer including a second gate electrode of the second transistor;
a third insulating layer on the fourth conductive layer; and
a fifth conductive layer on the third insulating layer, the fifth conductive layer including a second source electrode and a second drain electrode of the second transistor; and optionally
wherein the display panel further includes:
a first planarization layer on the fifth conductive layer;
a sixth conductive layer on the first planarization layer;
a second planarization layer on the sixth conductive layer; and
a seventh conductive layer on the second planarization layer.

11. The touch display device according to claim 10, wherein the seventh conductive layer extends from the first area to a second connection pattern from the plurality of second connection patterns on the second area; or optionally
wherein the display panel further includes:
a light emitting diode on the seventh conductive layer; and
an encapsulation layer on the light emitting diode, the encapsulation layer including:
a first inorganic encapsulation layer on the light emitting diode;
a first organic encapsulation layer on the first inorganic encapsulation layer;
a second inorganic encapsulation layer on the first organic encapsulation layer;
a second organic encapsulation layer on the second inorganic encapsulation layer; and
a third inorganic encapsulation layer on the second organic encapsulation layer.

12. The touch display device according to any one of claims 5-11, wherein the touch sensor comprises:
a third buffer layer on the display panel;
a plurality of bridge electrodes on the third buffer layer;
a fourth insulating layer on the plurality of bridge electrodes, wherein the plurality of first sensing electrodes and the plurality of second sensing electrodes are on the fourth insulating layer; and
a protection layer on the plurality of first sensing electrodes and the plurality of second sensing electrodes.

13. The touch display device according to claim 12, wherein the plurality of bridge electrodes include a first bridge electrode on the first area and a second bridge electrode on the second area,
wherein in the first area, a first sensing electrode from the plurality of first sensing electrodes is electrically connected to the first bridge electrode through a first contact hole that passes through the fourth insulating layer, and in the second area, a second sensing electrode from the plurality of second sensing electrodes is electrically connected to the second bridge electrode through a second contact hole that passes through the fourth insulating layer.

14. The touch display device according to claim 12, wherein a first sensing electrode from the plurality of first sensing electrodes in the first area extends from the first area to a second connection pattern from the plurality of second connection patterns on the second area.

15. A touch display device, comprising:
a display panel comprising a first area of the display panel and a second area corresponding to a curved edge of the display panel that surrounds the first area, a plurality of first pixels in the first area of the display panel that are configured to emit light, and a plurality of second pixels in the second area of the display panel that are configured to emit light; and
a touch sensor on the display panel, the touch sensor including:
a plurality of first sensing electrodes in the first area, the plurality of first sensing electrodes configured to sense touch of the first area;
a plurality of second sensing electrodes that are spaced apart from each other in the second area, the plurality of second sensing electrodes configured to sense touch of the second area; and
a plurality of connection lines in the second area, at least one connection line from the plurality of connection lines between a pair of second sensing electrodes from the plurality of second sensing electrodes and electrically connecting together the pair of second sensing electrodes.
